# EUROPÄISCHE PATENTSCHRIFT

(11) **EP 1 392 095 B1**
(45) Veröffentlichungstag und Bekanntmachung des Hinweises auf die Patenterteilung: **13.07.2005**
(21) Anmeldenummer: 03018561.5
(22) Anmeldetag: 18.08.2003
(51) Int. Cl.: H05K 7/20, F04D 25/08

(54) **Lüftermodul für ein elektrisches Gerät**
Fan unit for an electrical device
Unité ventilateur pour un appareil électrique

(30) Priorität: 21.08.2002 DE 10238283
(43) Veröffentlichungstag der Anmeldung: 25.02.2004
(73) Patentinhaber: Fujitsu Siemens Computers GmbH, 80807 München (DE)
(72) Erfinder: Schmidt, Heinrich, 33129 Delbrück (DE); Knoop, Franz Josef, 33142 Büren-Steinhausen (DE)
(74) Vertreter: Epping Hermann & Fischer

(56) Entgegenhaltungen:
- DE-U- 20 006 847
- DE-U- 20 014 274
- US-A1- 2002 086 574
- US-B1- 6 373 698
- "PLUGGABLE FAN ASSEMBLY" IBM TECHNICAL DISCLOSURE BULLETIN, IBM CORP. NEW YORK, US, Bd. 32, Nr. 3A, 1. August 1989 (1989-08-01), Seiten 342-343, XP000049444 ISSN: 0018-8689

## Beschreibung

Die Erfindung betrifft ein Lüftermodul mit den Merkmalen des Oberbegriffs des Anspruch 1.

Derartige Lüftermodule sind bekannt und dienen dazu, ein elektrisches Gerät zu kühlen. Dabei wird zumindest ein Lüftermodul so in das elektrische Gerät eingesetzt, daß es Luft aus der Umgebung des Geräts in das Gehäuse des elektrischen Geräts einbläst. Um die Kühlleistung zu erhöhen und eine Redundanz bereitzustellen, werden oft mehrere Lüftermodule hintereinandergeschaltet, so daß sich ein gemeinsamer Luftstrom durch mehrere Lüftermodule ergibt. Für erhöhte Anforderungen werden zwei Reihen mit Lüftermodulen vorgesehen, die unabhängig voneinander arbeiten.

Typischerweise werden solche elektrischen Geräte in Geräteschränke eingebaut. Die Geräte werden in den Geräteschrank eingeschoben und ihre Lüfter saugen die Umgebungsluft von der Frontseite her an. Die Luft wird dann an der Rückseite der elektrischen Geräte ausgeblasen und über eine Luftabführung des Schranks, beispielsweise über einen Schlauch, abgeführt.

Ein wichtiges Kriterium für Lüftermodule ist die sogenannte Hot-Plug-Fähigkeit, um in hochverfügbaren Systemen eingesetzt werden zu können. Dies bedeutet, daß Lüftermodule im laufenden Betrieb eines elektrischen Geräts ausgetauscht werden können. Die Lüftermodule müssen deswegen so ausgestaltet sein, daß keine komplizierten Anschluß- oder Befestigungsvorgänge erforderlich sind, die das Abschalten des Geräts erforderlich machen.

Ein Lüftermodul der eingangs genannten Art ist beispielsweise aus der DE 100 52 708 A1 bekannt. Das dort offenbarte Lüftermodul besitzt Kontaktflächen an einer Seitenfläche. Das Lüftermodul ist so ausgestaltet, daß es von oben in Lüfterschächte eines elektrischen Geräts eingefügt werden kann. In den Lüfterschächten sind Führungen vorgesehen, die sicherstellen, daß das Lüftermodul in einer bestimmten Lage positioniert und dort verriegelt wird. Die Kontaktflächen sind an einer Seitenwand angeordnet, um mit Gegenkontakten an einer senkrecht im Gehäuse stehenden Leiterplatte in Verbindung treten zu können. Die vorgeschlagene Anordnung ist verhältnismäßig aufwendig, weil Lüfterschächte mit Führungen vorgesehen werden müssen, damit die Lüftermodule in der richtigen Position zu liegen kommen.

Die DE 200 06 847 U1 offenbart eine Lüfteranordnung, bei der zwei Lüfter in einem gemeinsamen Gehäuse angeordnet sind. Das gemeinsame Gehäuse weist elektrische Kontakte auf, die zur Kontaktierung mit Gegenkontakten einer Grundplatte vorgesehen sind. Außerdem weist das Gehäuse Rastelemente auf zur Verrastung des Gehäuses mit der Grundplatte.

Aus der US-B1-6 373 698 ist ein Lüftermodul bekannt, das an einer Unterseite Kontaktelemente aufweist zur Zuführung einer Betriebsspannung für den Elektromotor. Außerdem sind Rastelemente vorgesehen zur Verrastung mit Ausnehmungen eines Führungsteils.

Aufgabe der Erfindung ist es daher, ein Lüftermodul für ein elektrisches Gerät anzugeben, das die erforderliche Hot-Plug-Fähigkeit besitzt und keinen Lüfterschacht zu seiner Positionierung in einem elektrischen Gerät erforderlich macht. Insbesondere soll es einfach im Aufbau sein.

Diese Aufgabe wird durch ein Lüftermodul der eingangs genannten Art mit den kennzeichnenden Merkmalen des Anspruchs 1 gelöst.

Der Vorteil des erfindungsgemäßen Lüftermoduls besteht darin, daß es mit der ohnehin vorzusehenden Grundplatte, beispielsweise einer Leiterplatte, sowohl elektrisch als auch mechanisch verbunden werden kann. Mehrere Lüftermodule sind so hintereinander plazierbar, daß sie einen gemeinsamen Luftkanal bilden, in dem die Lüfter in Reihe geschaltet sind. Da mehrere Lüftermodule nicht aneinander befestigt werden müssen, können sie sehr einfach und schnell ausgetauscht werden. Durch die Kontaktelemente, die mit Gegenkontaktelementen auf der Grundplatte zusammenwirken können, muß sich ein Techniker, der den Austausch eines Lüftermoduls vornimmt, nicht um den elektrischen Anschluß des Lüftermoduls kümmern.

Das Gehäuse des Lüftermoduls, in das der Lüfter aufgenommen ist, besteht in der erfindungsgemäßen Ausgestaltung aus zwei Gehäuseschalen, die miteinander verrastet sind. Dabei ist es insbesondere von Vorteil, daß die Gehäuseschalen identisch ausgestaltet sind, so daß nur ein Werkzeug zu ihrer Herstellung erforderlich ist.

Bei einer solchen Ausgestaltung können in Ausnehmungen einer Gehäusehälfte Kontaktelemente bildende Federstiftkontakte eingesetzt werden, während in die entsprechenden Ausnehmungen der anderen Gehäuseschale zumindest ein Codierstift eingesetzt werden kann, um ein falsches Einsetzen des Lüftermoduls zu verhindern.

In einer günstigen Ausführung sind an mindestens einer an die erste Seitenfläche angrenzenden Seitenfläche Entriegelungslaschen vorgesehen, durch die Rastelemente entriegelbar sind.

Die Erfindung wird nachfolgend anhand eines Ausführungsbeispiels näher erläutert. Es zeigt.
- Figur 1: eine dreidimensionale Ansicht eines erfindungsgemäßen Lüftermoduls
- Figur 2: eine Anordnung mit einem erfindungsgemäßen Lüftermodul und einer geeigneten Grundplatte,
- Figur 3: eine dreidimensionale Ansicht einer Gehäuseschale und
- Figur 4: das Lüftermodul von Figur 1 mit einseitig abgenommener Gehäuseschale.

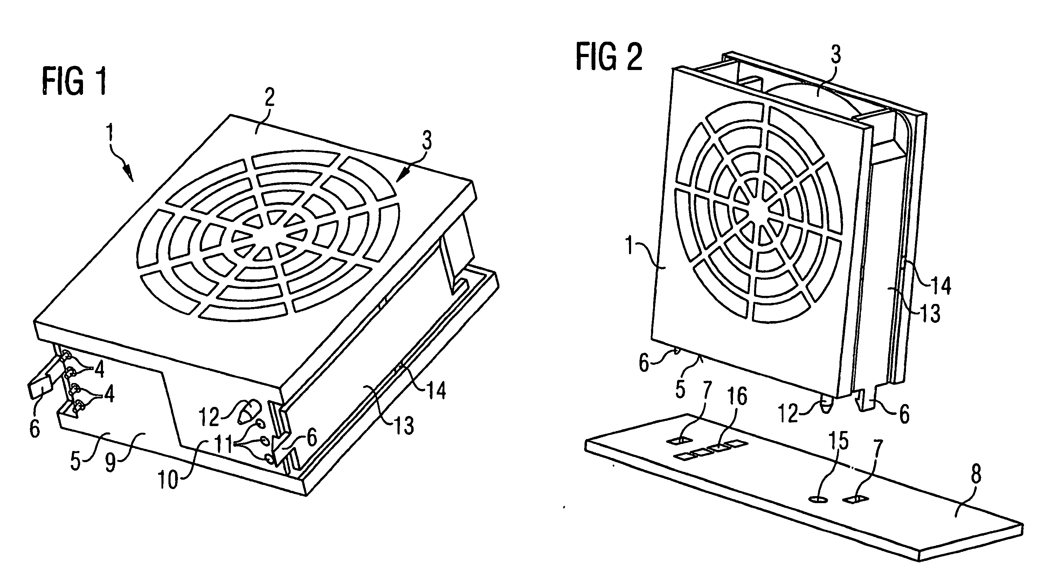

In Figur 1 ist ein erfindungsgemäßes Lüftermodul gezeigt. Das Lüftermodul weist ein Gehäuse 2 auf, das aus zwei Gehäuseschalen 9 und 10 zusammengesetzt ist. Die beiden Gehäuseschalen 9 und 10 sind identisch aufgebaut. Auf der in Figur 1 oben liegenden Seite des Lüftermoduls ist in der Gehäuseschale 10 ein Gitter vorgesehen, durch das Luft durchtreten kann. An der gegenüberliegenden Seite des Lüftermoduls 1 ist ebenfalls ein solches Lüftergitter vorgesehen. Dazwischen liegt ein Lüfter 3, der in der Darstellung von Figur 1 nicht zu erkennen ist.

An einer ersten Seitenfläche des Gehäuses 2 sind vier Kontaktelemente 4 zu sehen, die durch Federstiftkontakte gebildet sind. Die Federkontaktstifte 4 sind in entsprechende Ausnehmungen der Gehäuseschale 9 eingesetzt. Darüber hinaus sind zwei Rastelemente 6 vorgesehen, die ebenfalls an der ersten Seitenfläche 5 des Lüftermoduls 1 angeordnet sind. Auf der anderen Seite der ersten Seitenfläche 5 sind ebenfalls Ausnehmungen 11 in der Gehäuseschale 10 vorhanden, da die Gehäuseschale 10 eine mit der Gehäuseschale 9 identische Konstruktionen aufweist. In einer der Ausnehmungen 11 ist ein Codierstift 12 eingesetzt. Dieser stellt sicher, daß das erfindungsgemäße Lüftermodul 1 nicht falsch in ein elektrisches Gerät eingesetzt werden kann.

An dem an die erste Seitenfläche 5 angrenzenden Seitenflächen des Gehäuses 2 sind Entriegelungslaschen 13 vorgesehen, die um eine Achse 14, die durch Zapfen gebildet ist, schwenkbar sind. Die Betätigung der Entriegelungslaschen 13 erfolgt von der der ersten Seitenfläche gegenüberliegenden Seite des Lüftermoduls 1. Dadurch ist ermöglicht, daß auch bei mehreren nebeneinander in einem elektrischen Gerät aufgenommenen Lüftermodulen 1 eine einfache Entriegelung eingesetzter Lüftermodule möglich ist, wodurch diese leicht ausgetauscht werden können.

In der Figur 2 ist dargestellt, wie ein erfindungsgemäßes Lüftermodul 1 auf eine Grundplatte 8 aufgesetzt werden kann. In der Grundplatte 8 sind zwei Gegenrastelemente 7 vorgesehen, die in diesem Fall durch einfache Ausnehmungen gebildet sind. Diese sind so angeordnet, daß sie mit den Rastelementen 6 des Lüftermoduls 1 zusammenwirken. Beim Aufsetzen des Lüftermoduls 1 auf die Grundplatte 8 greifen die Rastnasen in die Ausnehmungen 7 ein und verrasten dort. Das Lüftermodul 1 ist damit sicher auf der Grundplatte 8 mechanisch befestigt. Außerdem ist in der Grundplatte 8 ein Führungsloch 15 vorgesehen, in das beim Einstecken des Lüftermoduls 3 der Codierstift 12 eingeführt wird. Da nur auf einer Seite der Grundplatte 8 ein Führungsloch 15 vorgesehen ist, kann das Lüftermodul 1 nicht falsch herum eingesetzt werden.

Außerdem sind auf der Grundplatte 8 Gegenkontaktflächen 16 vorgesehen, die so angeordnet sind, daß sie im eingesteckten Zustand des Lüftermoduls 1 mit den Kontaktelementen 4 in Verbindung sind. Auf diese Weise erfolgt neben der mechanischen Befestigung des Lüftermoduls 1 auf der Grundplatte 8 auch eine elektrische Verbindung zwischen der Grundplatte 8, die vorteilhafterweise eine Leiterplatte ist, und dem Lüftermodul 1.

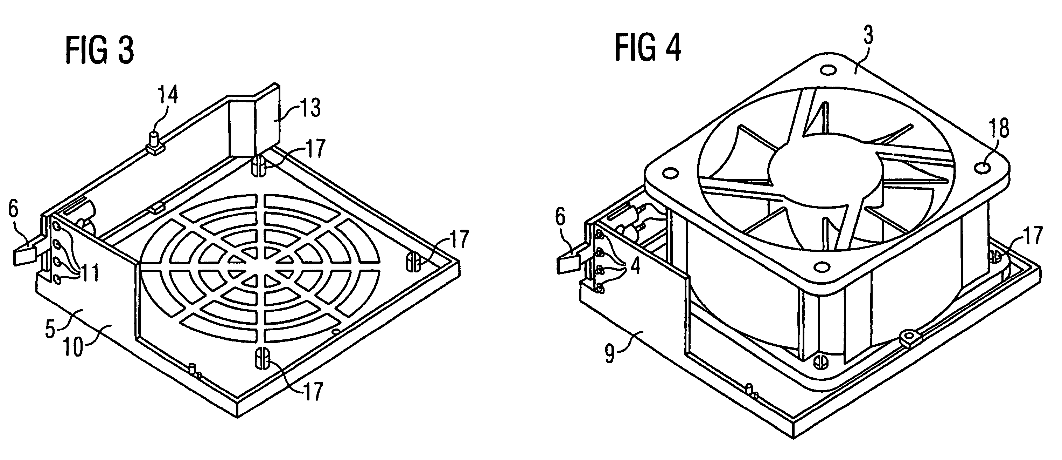

In der Figur 3 ist die Gehäuseschale 9 von der Innenseite gezeigt. Von der Seitenfläche 5 her sind die Ausnehmungen 11 zu erkennen, in die später die Federstiftkontakte bzw. der Codierstift 12 eingesetzt werden. Auch in Figur 3 ist gut zu erkennen, daß an den Entriegelungslaschen 13 Zapfen 14 angeformt sind, über die die Entriegelungslaschen schwenkbar gelagert sind.

In Figur 4 sind die restlichen Komponenten des Lüftermoduls 1 zu sehen. Es handelt sich dabei um die andere Gehäuseschale 10, in die ein Lüfter 3 eingesetzt ist. Zapfen 17 sind an der Gehäuseschale 9 dabei so angeordnet, daß sie in Befestigungslöcher 18 des Lüfters 3 eingreifen. In die Ausnehmungen der Gehäuseschale 9 sind Federstiftkontakte 4 eingesetzt, die auf der Innenseite mit den Anschlußlitzen des Lüfters 3 verbunden sind. Im Ausführungsbeispiel von Figur 4 sind die Anschlußlitzen mit den Federstiftkontakten verlötet. Es wäre aber genauso möglich, eine Steckverbindung vorzusehen, wobei die Anschlußlitzen mit einem Stecker verbunden wären, der an der Gehäuseschale 9 eingesteckt werden könnte zur elektrischen Verbindung mit den Federstiftkontakten 4.

Wie aus den Figuren 3 und 4 anschaulich zu erkennen ist, kann die Gehäuseschale 10 einfach auf die Anordnung aus Figur 4 aufgesetzt werden. Die Gehäuseschalen 9 und 10 verrasten miteinander und bilden so ein komplettes Gehäuse 2.

### Bezugszeichenliste

- 1: Lüftermodul
- 2: Gehäuse
- 3: Lüfter
- 4: Federstiftkontakte
- 5: erste Seitenfläche
- 6: Rastelemente
- 7: Gegenrastelemente
- 8: Grundplatte
- 9: Gehäuseschale
- 10: Gehäuseschale
- 11: Ausnehmungen
- 12: Codierstift
- 13: Entriegelungslasche
- 14: Zapfen
- 15: Führungsloch
- 16: Gegenkontaktfläche
- 17: Zapfen
- 18: Löcher

## Patentansprüche

1. Lüftermodul für ein elektrisches Gerät mit
- einem Gehäuse (2),
- einem Lüfter (3), der von dem Gehäuse (2) zumindest teilweise umschlossen wird, zur Erzeugung eines Luftstroms, wobei der Lüfter (3) einen Elektromotor aufweist, und
- Kontaktelementen (4), die an einer ersten Seitenfläche (5) des Gehäuses (2) angeordnet sind zur Zuführung einer Betriebsspannung für den Elektromotor,
- Rastelemente (6) zur Verrastung des Lüftermoduls (1) mit Gegenrastelementen (7) einer senkrecht zu einer Einsteck richtung verlaufenden Grundplatte (8),
**dadurch gekennzeichnet, daß**
das Gehäuse (2) aus zwei Gehäuseschalen (9, 10) besteht, die miteinander verrastet und identisch ausgestaltet sind.

2. Lüftermodul nach Anspruch 1,
**dadurch gekennzeichnet, daß** die Rastelemente (6) im Bereich der ersten Seitenfläche (5) des Gehäuses (2) angeordnet sind.

3. Lüftermodul nach Anspruch 1,
**dadurch gekennzeichnet, daß**
die Gehäuseschalen (9, 10) Ausnehmungen (11) aufweisen, wobei in die Ausnehmungen einer Gehäuseschale (9) die Kontaktelemente (4) bildenden Federstiftkontakte eingesetzt sind und in die entsprechenden Ausnehmungen der anderen Gehäuseschale (10) mindestens ein Codierstift (12) eingesetzt ist.

4. Lüftermodul nach einem der Ansprüche 1 bis 3,
**dadurch gekennzeichnet, daß**
an mindestens einer an die erste Seitenfläche (5) angrenzenden Seitenfläche des Gehäuses (2) Entriegelungslaschen vorgesehen sind, durch die die Rastelemente (6) entriegelbar sind.

5. Lüftermodul nach einem der Ansprüche 1 bis 4,
**dadurch gekennzeichnet, daß** zumindest eine der Gehäuseschalen (9,10) ein Schutzgitter aufweist, durch das der erzeugte Luftstrom hindurchtritt.

6. Elektrisches Gerät mit einem Gehäuse, das eine Luftdurchtrittsöffnung aufweist, wobei im Gehäuseinneren im Bereich der Luftdurchtrittsöffnung mindestens ein Lüftermodul (1) nach einem der Ansprüche 1 bis 5 angeordnet ist.

7. Elektrisches Gerät nach Anspruch 6,
**dadurch gekennzeichnet, daß**
mehrere Lüftermodule (1) nach einem der Ansprüche 1 bis 5 derart hintereinander angeordnet sind, daß ein Luftkanal gebildet ist, in dem die Lüfter (3) in Reihe geschaltet sind zur Erzeugung eines Luftstroms.

8. Elektrisches Gerät nach Anspruch 6 oder 7,
**dadurch gekennzeichnet,**
**daß** mehrere Lüftermodule (1) nebeneinander angeordnet sind und sich dabei über die gesamte Breite des Gehäuses erstrecken.

9. Elektrisches Gerät nach einem der Ansprüche 6 bis 8,
**dadurch gekennzeichnet, daß**
es sich um eine Datenverarbeitungsvorrichtung handelt.

## Claims

1. Fan unit for an electrical device, having
- a housing (2),
- a fan (3), which is at least partially surrounded by the housing (2), for generating an air stream, the fan (3) having an electric motor, and
- contact elements (4), which are arranged at a first side face (5) of the housing (2) for supplying an operating voltage for the electric motor,
- latching elements (6) for latching the fan unit (1) to mating latching elements (7) of a baseplate (8) running perpendicular to an insertion direction,
**characterized in that** the housing (2) comprises two housing shells (9, 10) which are latched to one another, and are identical in form.

2. Fan unit according to Claim 1, **characterized in that** the latching elements (6) are arranged in the region of the first side face (5) of the housing (2).

3. Fan unit according to Claim 1, **characterized in that** the housing shells (9, 10) have recesses (11), the spring pin contacts which form contact elements (4) being inserted into the recesses in a housing shell (9), and at least one coding pin (12) being inserted into the corresponding recesses in the other housing shell (10).

4. Fan unit according to one of Claims 1 to 3, **characterized in that** unlocking tabs, by means of which the latching elements (6) can be unlocked, are provided on at least one side face, adjoining the first side face (5), of the housing (2).

5. Fan unit according to one of Claims 1 to 4, **characterized in that** at least one of the housing shells (9, 10) has a protective grate through which the air stream that is generated passes.

6. Electrical device having a housing with an air passage opening, at least one fan unit (1) according to one of Claims 1 to 5 being arranged in the interior of the housing in the region of the air passage opening.

7. Electrical device according to Claim 6, **characterized in that** a plurality of fan units (1) according to one of Claims 1 to 5 are arranged behind one another in such a manner as to form an air passage in which the fans (3) are connected in series in order to generate an air stream.

8. Electrical device according to Claim 6 or 7, **characterized in that** a plurality of fan units (1) are arranged next to one another and extend over the entire width of the housing.

9. Electrical device according to one of Claims 6 to 8, **characterized in that** it is a data-processing device.

## Revendications

1. Module de ventilateur pour un appareil électrique comprenant
- un corps (2),
- un ventilateur (3), qui est entouré au moins en partie par le corps (2), de production d'un courant d'air, le ventilateur (3) ayant un moteur électrique et
- des éléments (4) de contact, qui sont disposés sur une première face (5) latérale du corps (2) pour appliquer une tension de fonctionnement au moteur électrique,
- des éléments (6) d'encliquetage du module (1) de ventilateur avec des éléments (7) d'encliquetage d'une plaque (8) de base s'étendant perpendiculairement à une direction d'enfichage,
**caractérisé en ce que** le corps (2) est constitué de deux coquilles (9, 10) de corps qui s'encliquètent mutuellement et qui sont constituées de façon identique.

2. Module de ventilateur suivant la revendication 1,
**caractérisé en ce que** les éléments (6) d'encliquetage sont disposés dans la zone de la première face (5) latérale du corps (2).

3. Module de ventilateur suivant la revendication 1,
**caractérisé en ce que** les coquilles (9, 10) de corps ont des trous (11), les contacts à broche élastique formant les éléments (4) de contact étant insérés dans les trous d'une coquille (9) du corps et au moins une cheville (12) de codage est insérée dans les trous correspondants de l'autre coquille (10) du corps.

4. Module de ventilateur suivant l'une des revendications 1 à 3,
**caractérisé en ce qu'**il est prévu sur au moins l'une des faces latérales du corps (2), voisine de la première face (5) latérale, des pattes de déverrouillage par lesquelles les éléments (6) d'encliquetage peuvent être déverrouillés.

5. Module de ventilateur suivant l'une des revendications 1 à 4,
**caractérisé en ce qu'**au moins l'une des coquilles (9, 10) du corps a une grille de protection à travers laquelle le courant d'air produit peut passer.

6. Appareil électrique comprenant un corps, qui a une ouverture de passage pour de l'air, au moins un module (1) de ventilateur suivant l'une des revendications 1 à 5 étant disposé à l'intérieur du corps dans la région de l'ouverture de passage de l'air.

7. Appareil électrique suivant la revendication 6,
**caractérisé en ce que** plusieurs modules (1) de ventilateur suivant l'une des revendications 1 à 5 sont disposés les uns derrière les autres de façon à former un canal d'air dans lequel les ventilateurs (3) sont montés en série pour la production d'un courant d'air.

8. Appareil électrique suivant la revendication 6 ou 7,
**caractérisé en ce que** plusieurs modules (1) d'air sont disposés côte à côte et s'étendent sur toute la largeur du corps.

9. Appareil électrique suivant l'une des revendications 6 à 8,
**caractérisé en ce qu'**il s'agit d'un dispositif informatique.
